# EUROPEAN PATENT APPLICATION

(11) **EP 1 764 827 A1**
(43) Date of publication of application: **21.03.2007**
(21) Application number: 05447285.7
(22) Date of filing: 19.12.2005
(51) Int. Cl.: H01L 21/336, H01L 29/786, H01L 21/027

(54) **Recursive spacer defined patterning**

(30) Priority: 16.09.2005 US 717690 P
(71) Applicant: INTERUNIVERSITAIR MICROELEKTRONICA CENTRUM ( IMEC), 3001 Leuven (BE)
(72) Inventor: DeGroote, Bart, 3060 Oud-Heverlee (BE); Rooyackers, Rita, 3010 Kessel-Lo (BE)
(74) Representative: Van Malderen, Joëlle

(57) **Abstract**

The present invention relates to a method for the patterning of a plurality of fins in a MugFET device. The present invention is achieved by depositing at least one temporary pattern using photolithography. Further processing steps are a combination of depositing a conformal layer and spacer defined patterning of the conformal layer such that a very high density of fins can be achieved. The distance between the fins is no longer determined by photolithography (only used to define the temporary pattern which is removed in further processing) but by the thickness of the conformal layer (all fins are defined by spacers). Additionally an improved line edge roughness will be achieved for the fins using the method of the invention.

## Description

### Field of the Invention

The present invention is related to the field of semiconductor processing.

The present invention is further related to the field of patterning of fin structures within a semiconductor device and more specifically within multiple gate devices.

### Background of the Invention

As the scaling of transistor dimensions in planar devices continues, short-channel effects become more of an issue.

MuGFET devices (multi-gate FET) can provide an answer to this problem. Due to their unique 3-D architecture with gates wrapped around a thin silicon fin, they show excellent gate control over the channel. The MuGFET's non-planarity however puts high demands on processing engineers and lithographers who have to deal with specific etching, implantation and patterning issues as well as difficulties in tuning the threshold voltage.

The fin width needs to be in the sub-25 nm regime to achieve good suppression of short-channel effects. The narrower the fin, the better the gate control and the more robust the device is with respect to short-channel effects. A narrow fin, on the other hand, results in an increased source/drain resistance and can suffer more from line edge roughness, so a trade-off has to be made between very narrow fins to limit short-channel effects and wider fins to have a less source-drain resistance. The above-described architecture is that of a single-fin device. However, most of the time multiple-fin devices are used with several fins contacting large source/drain blocks to improve current drivability.

When using multiple fins in a finFET device, the fin density or in other words the distance between the fins is important.

US 6,706,571 by Yu et al. discloses a method for forming a plurality (two) of fins in a finFET device by forming spacers on the sidewalls of a patterned trench and using these spacers to etch fins in the layer underneath. This method can result in narrow fins with less line edge roughness compared to resist based patterning (e.g. with 193nm lithography). In the method from Yu et al., two fins are obtained starting from one lithographic pattern, therefore doubling the density of the lines. However, the distance between the individual fins is still determined by lithography. A method that further increases the fin density by keeping the fin distance as small as possible is therefore still required to obtain finFET devices with better performance.

### Summary of the Invention

The present invention provides a method for forming a mask for patterning a layer underneath, in the manufacture of a semiconductor device.

A method according to the invention can comprise the step of depositing over a patterned structure and etching back a conformal layer, such that the sidewalls of said patterned structure are used for forming a first generation of spacer-like structures (also referred to as spacers).

The patterned structure can be removed such that both sidewalls of each spacer of said first generation can be used for forming a second generation of spacers.

After removal of the first generation of spacers, said second generation of spacers can be used as a mask for patterning fins in the layer underneath.

Similarly, another (third, fourth, etc.) generation of spacers can be formed using the sidewalls (each sidewall made available or only outer sidewalls of outer spacers) of the previous (respectively second, third, etc.) generation of spacers. And before using the last generation (n generation) of spacers as a mask for fins patterning, the previous generation (n-1 generation) of spacers is removed.

A method of the invention supposes that the material used for the temporary pattern can be selectively removed with respect to the material used for the first and/or second generation(s) of spacers.

Likewise, the material used for a generation of spacers can be selectively removed with respect to the material used for the next generation.

A method of the invention allows patterning multiple fins wherein the distance between 2 fins is defined by the thickness of the conformal layer deposited and etched back to form the spacers.

More particularly, the present invention provides a method for forming a mask on a layer to be patterned, in the manufacture of a semiconductor device, comprising the steps of:
- depositing over one or more temporary structure(s) made of a first material, a first conformal layer of a second material,
- removing said first conformal layer such as to form a first generation of spacers made of said second material,
- removing said temporary structure(s),
- depositing over said first generation of spacers a second conformal layer made of a third material,
- removing said second conformal layer such as to form a second generation of spacers made of said third material,
- removing the first generation of spacers made of said second material.

A method according to the invention can further comprise the steps of:
- depositing a third conformal layer made of said second material over said second generation of spacers,
- removing said third conformal layer such as to form a third generation of spacers made of said second material,
- removing the second generation of spacers made of said third material.

In a method of the invention wherein said third conformal layer is made of said second material, the step of removing said first generation of spacers is optional.

Alternatively, said third conformal layer can be made of a fourth material.

In a method according to the invention, said temporary structure(s) can be (an) inlaid structure(s). Said temporary structure(s) is/are preferably freestanding structure(s). Said temporary structure(s) can be created using photolithography. Said temporary structure(s) can also be a previous generation of spacers.

Preferably, said layer underneath to be patterned (2) is a Silicon On Insulator (SOI) wafer.

In a method of the invention, said first material can be silicon-dioxide, said second material silicon-nitride (SiₓN_{y}), and said third material silicon-dioxide.

Preferably, said first material is silicon-dioxide, said second material is silicon-nitride and said third material is SiON.

Alternatively, in a method according to the invention, said first material can be silicon-nitride, said second material silicon-dioxide, and said third material silicon-nitride.

Alternatively, said first material can be silicon or Germanium or Silicon-Germanium, said second material silicon-dioxide and said third material silicon-nitride.

In a method of the invention, said nitride can be deposited by means of conformal chemical vapor deposition techniques such as LP-CVD (low-pressure CVD) and PE-CVD (plasma-enhanced CVD).

Said silicon-dioxide can be CVD deposited TEOS-oxide (using TetraEthylOrthoSilicate as a precursor).

In a method according to the invention, said step of removing the temporary structure(s) (3) can be an etching process, more particularly a wet etching process.

In a method according to the invention, said step of removing said generation of spacers can be an etching process, more particularly a wet etching process.

In a method according to the invention, said conformal layer(s) can be etched back by means of reactive ion etching using a fluor comprising plasma.

A method according to the invention can be used for the manufacture of a MugFET device, wherein said mask is used for patterning a plurality of fins in said underneath layer to be patterned (2).

In a method according to the invention, said patterning for fins can be used in combination with a resist-based patterning of source/drain patterning.

Another object of the present invention is a device (in particular a MuGFET device) obtainable by a method according to the invention.

In a device according to the invention, the distance between adjacent fins is preferably comprised between (about) 10 nm and (about) 80 nm, more preferbaly the distance between adjacent fins is (about) 20 nm.

In a device according to the invention, the width of the fins is preferably comprised between (about) 10 nm and (about) 20 nm.

### Brief Description of the Drawings

All drawings are intended to illustrate some aspects and embodiments of the present invention. Devices are depicted in a simplified way for reason of clarity. Not all alternatives and options are shown and therefore the invention is not limited to the content of the given drawings. Like numerals are employed to reference like parts in the different figures.

Figures 1A-1I are cross-sectional views illustrating the different processing steps for forming four dense fins (fin-quadrupling) according to a method of the present invention.

Figure 2 shows a XSEM picture presenting the result after removal of the temporary pattern creating freestanding (nitride) spacers.

Figure 3 shows XSEM pictures presenting the result after etching back the second conformal layer such that a second set of spacers (silicon-dioxide) 31 is created adjacent to the first set of spacers (nitride) 30. A contrast layer is deposited onto the spacers to make the difference between nitride and silicon-dioxide clearer.

Figure 4 shows XSEM pictures presenting the result after applying the method of fin quadrupling creating four individual fins in the SOI layer.

Figures 5A - 5K are cross-sectional views illustrating the different processing steps for forming six dense fins (fin-sextupling) according to a method of the present invention.

Figure 6A to 6F illustrates the fin quadrupling processing (as described in the examples). Figure 6A illustrates the sacrificial hardmask opening to form the temporary structure. Figure 6B illustrates the sacrificial nitride spacer definition. Figure 6C illustrates final spacer formation. Figure 6D illustrates the sacrificial spacer removal (with use of a contrast layer). Figure 6E illustrates the fin etch using the silicon-dioxide spacers as hardmask. Figure 6F illustrates the fins after silicon-dioxide hardmask (spacers) removal.

### Detailed Description of the Invention

A method is disclosed for forming a mask structure upon a layer to define a pattern in said layer.

Said mask structure is formed by first depositing (or forming) a temporary structure onto said layer and forming vertical structures (also referred to in this application as spacers) (out of a deposited conformal layer) onto the sidewalls of said temporary structure.

Said temporary structure is then removed and spacer structures are formed onto the sidewalls of previously formed spacer structures.

By removing intermediate spacer structures, the distance between the remaining spacer structures is defined by the thickness of said deposited conformal layer.

The remaining spacer structures can then be used as a mask to define a dense pattern in the layer underneath.

The method of the invention enables to pattern a high density of structures into a layer, said high density of structures further defined as structures which are very close to each other such that these structures can not be defined by classical photolithographic methods.

The distance between these structures is preferably in the range of 10nm up to 80nm and more preferred in between 20nm to 40nm.

An object of this invention is a method to create multiple fins for use in a multiple gate structure. The distance between the individual fins is in the range of 10nm up to 80nm and more preferred in the range of 10nm to 40nm.

The width of said fins is preferably lower than 20nm.

The method is further characterized as a method for the patterning of a plurality of fins (i.e. more than 2 fins) in a finFET device whereby the distance between the individual fins is determined by spacer defined structures.

A spacer as referred to in this application is a vertical structure formed onto the sidewalls of a first structure (e.g. a temporary pattern).

After deposition of a layer of a suitable material over said first structure, an anisotropical removal (preferably etching) process is applied such that a vertical structure (a spacer) is obtained, said vertical structure further characterized as having a height at least equal or below the first structure and a width corresponding to the thickness of said deposited layer.

The patterning of fins using said spacer structures can be referred to as spacer defined patterning and is further characterized as a patterning wherein said spacers (as defined in the present application) are used as hardmask structures to create a pattern in the layer underneath.

Preferably, a method of forming multiple fins according to the invention comprises at least the steps of first creating a temporary pattern made of a first material.

Said temporary pattern can be a freestanding structure made of a first material using photolithography to define said temporary structure.

Alternatively and also preferred said temporary structure can be a trench-like structure (or in other words opening) made in a layer made of said first material, the width of said trench or opening can also be determined by photolithography.

Preferably said first material is a material commonly used in semiconductor processing as hardmask layer.

Onto (over) said temporary pattern a first conformal layer is deposited. Said first conformal layer is made of a second material.

Subsequently the first conformal layer is etched back (preferably by means of anisotropically etchback) such that a first set of spacers is formed onto the sidewalls of the temporary pattern.

The temporary pattern is then removed. The removal process can be a wet etching or a dry etching removal process depending on the material properties of said first material.

After removal of the temporary pattern two freestanding spacers structures are achieved, the distance between said spacers (also referred to as the first set of spacers) is determined by the width of the temporary structure, which is defined by photolithographic patterning.

Subsequently a second conformal layer made of a third material is uniformly deposited onto (over) the first set of spacers.

By anisotropically etching back said second conformal layer a second set of spacers is formed adjacent to the sidewalls of the first set of spacers.

The first set of spacers can then be removed such that four freestanding structures (spacers) made of said second material are obtained.

Said freestanding spacers can then be used as a mask to pattern fins in the layer underneath. As those freestanding spacers have been defined, an extra lithographic illumination (e.g. 193nm lithography) can be used to define large pads that will act as the source and drain of the MuGFET device. This means that the active area etch (or in other words the patterning of the SOI layer to form fins and Source/Drain pads) consists of a combination of spacer defined patterning and resist based patterning. In another MuGFET device concept Source/Drain pads are omitted and the fins directly contacted at contact level.

The so-far described method will be referred to in this application as "fin-quadrupling".

The method described as "fin-quadrupling" can be further extended such that six freestanding structures are formed that can be used as a mask to pattern six individual fins in the layer underneath. Said method will be referred to as "fin sextupling" in this application.

After formation of the second set of spacers as described above, a third conformal layer is deposited onto (over) said first and second set of spacers. Said third conformal layer is preferably identical to said second material.

Alternatively, a fourth material can be chosen as third conformal layer.

The third conformal layer is anisotropically etched back to form a third set of spacers. Said third set of spacers are situated onto the outer sidewalls of said second set of spacers and are preferably made of identical material of said first set of spacers (for etch selectivity in further processing).

By removing the second set of spacers, (2 times) three free standing spacer structures made of preferably identical materials are achieved. The removal of the second set of spacers is preferably done by means of a wet or dry etching removal process.

The first and third set of spacers can then be used as a mask set (or hardmask structure) to define fins in the layer situated underneath the spacer structures. The patterning of the fins is preferably done by means of an anisotropically dry etching process (which is selective towards said hardmask structure).

After removal of the first and third set of spacers a final structure is obtained with multiple fins (here six individual fins or two set of three fins) wherein the distance between adjacent fins in one set of fins is determined by the thickness of the deposited conformal layers.

The following description and examples illustrate various embodiments of the present invention. It will be appreciated that there are numerous variations and modifications of these embodiments that are possible.

It is an object of this invention to provide a method to create multiple fins for use in a multiple gate structure.

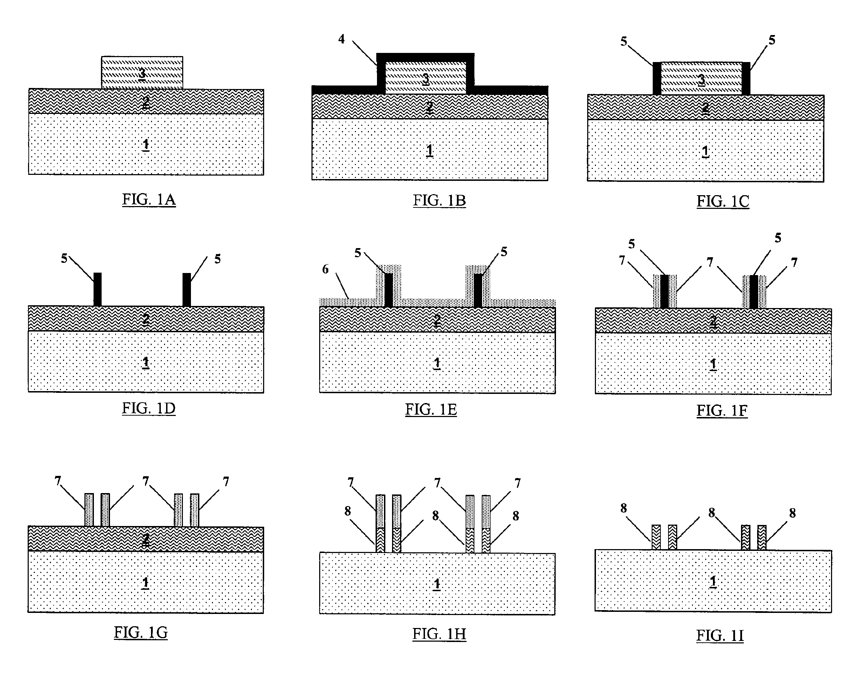

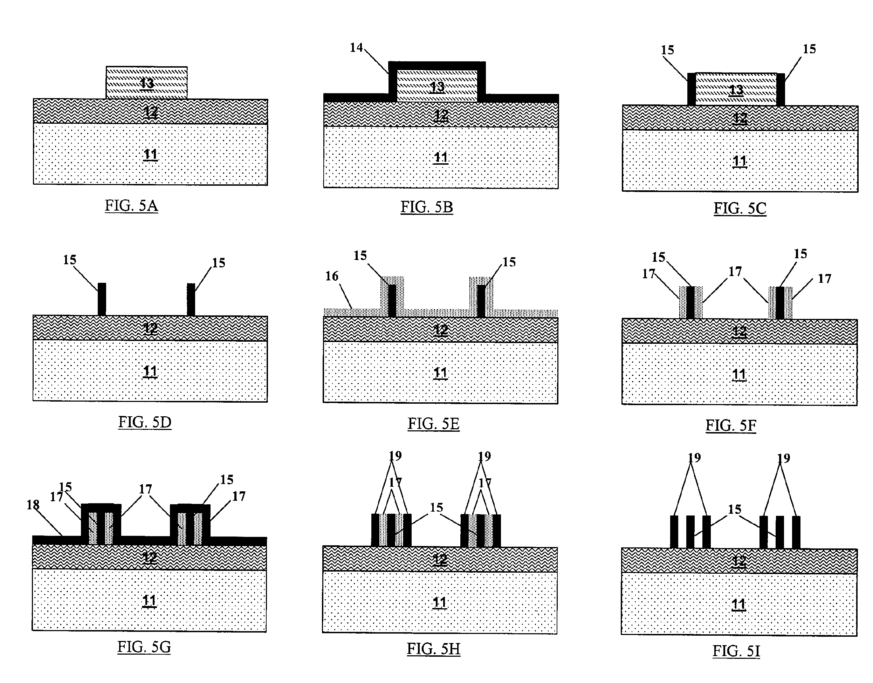

The method described in detail below is schematically shown in Figures 1A to 1I and Figures 5A-5K. It is further characterized as a method for the patterning of a plurality of fins in a multiple gate device (e.g. finFET) whereby the distance between individual fins is determined by spacer defined structures.

The method described below to form four individual fins is referred to as "fin quadrupling" because four fins are achieved starting from one temporary lithographic pattern.

The method can be further extended (including a repetition of steps) towards the formation of more individual fins (e.g. six) starting from one single temporary lithographic pattern. In the case six fins are formed, this method will be referred to as "fin sextupling".

The method of the invention can be extended towards formation of higher number of fins (forming 8 fins and more) by repeating the steps of forming sacrificial and permanent spacers, including the removal of sacrificial spacers and the use of the permanent spacers as a hardmask structure to define fins in the layer underneath. The method can be extended as long as the permanent spacers are suitable for use as hardmask structures.

### I. Method for "fin quadrupling".

Referring to Figure 1A the method preferably starts from a substrate. In case of finFET processing, said substrate is preferably a Silicon On Insulator (SOI) wafer. More specifically, the top Si- or SOI-layer **2** is preferably p-type mono-crystalline and <100>-oriented and has typically a thickness in between 50 nm to 200 nm.

The buried oxide (BOX) layer 1, which is situated underneath the SOI layer, has typically a thickness in between 100 nm to 200 nm.

The bulk Si part of the substrate is preferably p-type mono-crystalline and <100>-oriented.

The method of forming multiple fins starts with the formation of a temporary pattern or structure 3 made of a first material onto the SOI-layer 2.

Suitable materials to be used as first material are commonly used hardmask materials. A preferred example of said first material can be silicon oxide, most preferred said silicon-dioxide is a TEOS-oxide (a SiO₂ film deposited by CVD using TetraEthylOrthoSilicate or Si(OC₂H₅)₄ as a precursor).

To create said temporary pattern, first a layer made of said first material (with preferred thickness of around 80 nm) will be deposited onto the SOI layer followed by the deposition of photolithographic layers (not shown). Optical lithography (193 nm) is used to pattern the photosensitive layer(s).

The patterning of the temporary pattern in said first material is preferably done by means of reactive ion etching (also referred to as dry etching in this application) stopping on the SOI layer 2.

A fluor comprising plasma can be used for patterning said silicon-dioxide comprising layer such as TEOS-oxide, an example of such a plasma is a CF₄/CH₂F₂ comprising plasma (with bias power) obtaining a selectivity of 3:1 for Si:SiO₂.

Figure 1A shows the final structure comprising the temporary pattern 3 obtained after patterning and after removal of remaining photosensitive material and residues by means of a strip process.

Subsequently a first conformal layer 4 made of a second material is deposited. An example of said second material can be a silicon-nitride layer, with general chemical formula SiₓN_{y} or more specific Si₃N₄. Said silicon-nitride layer will be further referred to in this application as a "nitride" layer. Said nitride layer is preferably deposited by means of conformal deposition techniques such as Low-Pressure Chemical Vapor Deposition (LP-CVD), Plasma-Enhanced Chemical Vapor Deposition (PE-CVD), etc.

By means of reactive ion etching said first conformal layer 4 will be etched back stopping on the temporary structure 3, resulting in a first set of spacers 5 situated at the sidewalls of the temporary pattern 3.

Sufficient etch selectivity is required with respect to the SOI-layer 2.

In case the second material is a nitride layer, the etchback can be performed using e.g. a CH₃F/CF₄/O₂ plasma (with bias power) obtaining a selectivity of about 15:1 for both silicon-dioxide and Si compared to nitride.

If residues remain after etchback, a sulphuric peroxide mixture and an ammonia peroxide mixture can be used to remove the residual etch products.

The temporary pattern 3 is then removed, said removal process is preferably a wet etching process which is selective to both the first set of (nitride) spacers 5 as to the SOI-layer 2.

In case the temporary pattern is made of silicon-dioxide such as TEOS-oxide, the wet etching can be done in a diluted HF solution (e.g. 2.5 min. in 2% HF).

After removal of the temporary pattern 3 two freestanding spacer structures 5 are achieved, the distance between said spacers (also referred to as the first set of spacers) is determined by the width of the temporary structure, which is defined by photolithographic patterning.

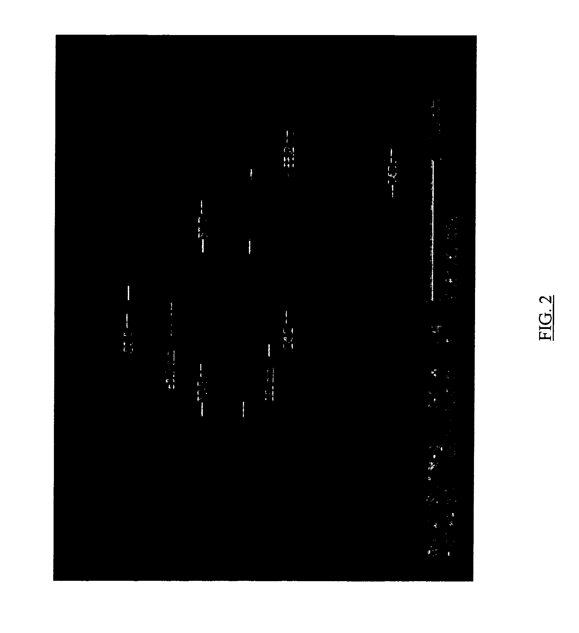

Figure 1D schematically shows the resulting structure after removal of the temporary pattern **3** and Figure **2** shows an XSEM image illustrating the freestanding (nitride) spacers **5**.

Subsequently a second conformal layer **6** made of a third material is conformally deposited onto the first set of spacers **5** as schematically shown in Figure 1E.

A silicon-dioxide (such as SiO₂) layer, such as TEOS-oxide can be used as third material (e.g. with aimed thickness of around 30 nm). The thickness of said deposited layer will determine the width of the fins obtained in the layer underneath. The minimal thickness of the fin that can be achieved is further dependent on the aspect ratio A (meaning the proportional relationship of the height *h* of the fin to the width *w* of the fin or *A*= *h_{fin}*/ *w_{fin}).* A too high aspect ratio needs to be avoided with respect to line collapse.

The second conformal layer **6** is then etched back using the SOI layer **2** as stopping layer.

A plasma comprising CF₄/CH₂F₂ can be used to perform this anisotropically etching of TEOS-oxide.

The result is a second set of spacers **7** situated adjacent to or next to the first set of (nitride) spacers **5**.

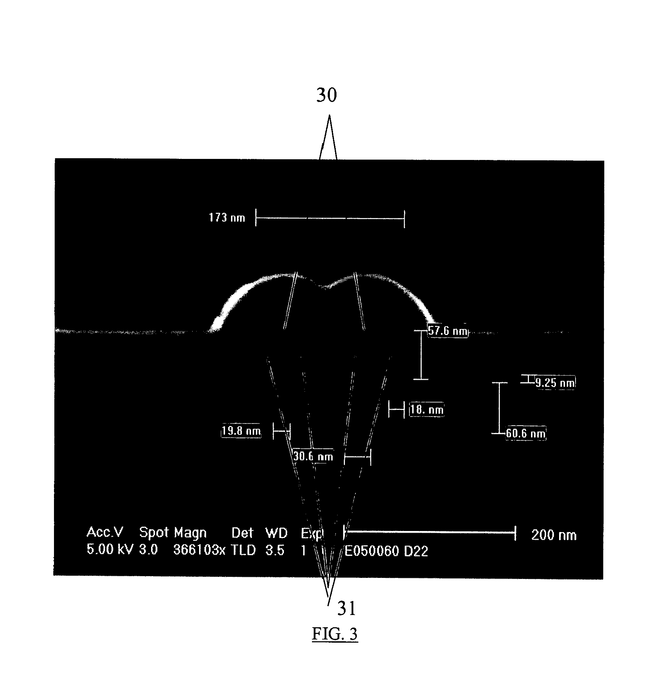

Figure 3 shows a XSEM photo illustrating the first **30** and second **31** set of spacers.

Figure 1F gives a schematically view on the obtained structure so far.

In case of "fin quadrupling" the first set **5** of spacers is then removed such that the second set of spacers **7** can be used as mask (also referred to as hardmask structure) to define multiple (four) fins **8** in de SOI layer underneath.

A CH₃/CF₄/O₂ comprising plasma can be used to remove the first set of spacers **5** and a HBr/Cl₂/O₂/CF₄ comprising plasma can be used to etch the fins **8** in the SOI layer **2** using spacers **7** as a mask.
The structure (after fin patterning) is shown schematically in Figure 1H, the final structure after removal of the second set of (silicon-dioxide) spacers **7** is shown in Figure 1I.

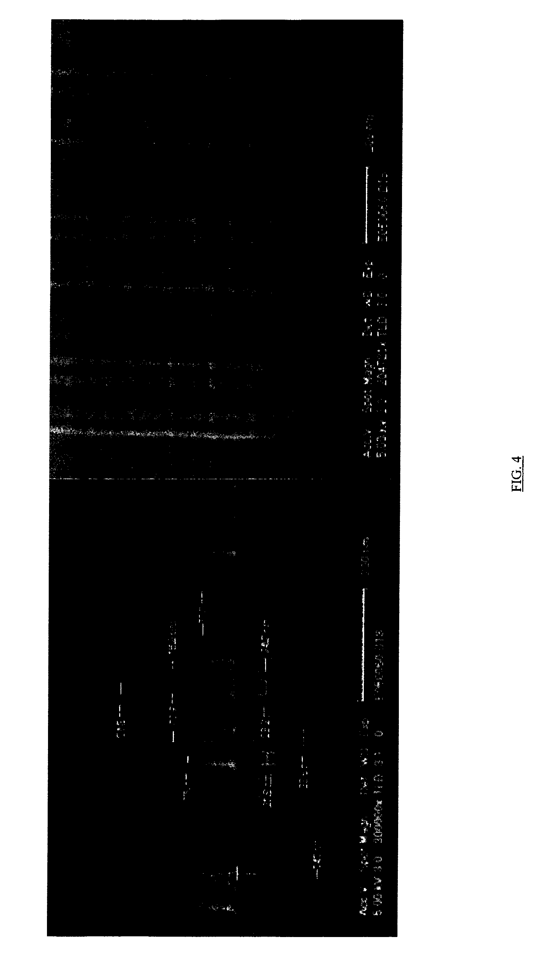

Figure 4 is a XSEM picture illustrating the fin quadrupling or in other words forming two sets of fins whereby the distance between the individual fins in each set of fins is defined by the thickness of the deposited conformal layer(s) and whereby the distance between the two sets of fins is defined by lithography.

A multiple fin structure is thus obtained with a very small distance in between the fins (creating a high fin density).

As an alternative and also preferred, the first material to be used to define the temporary pattern **3** can be silicon-dioxide (e.g. TEOS-oxide), the second material to be used to create the first set of spacers **5** can be nitride and the third material to be used to create the second set of spacers **7** can be SiON.

In another alternative, the first material to be used to define the temporary pattern **3** can be nitride, the second material to be used to create the first set of spacers **5** can be silicon-dioxide (e.g. TEOS-oxide) and the third material to be used to create the second set of spacers **7** can be nitride.

In still another alternative, the first material to be used to define the temporary pattern **3** can be silicon (Si) or Germanium (Ge) or Silicon-Germanium (SiₓGe_{y} e.g. x=70, y=30), the second material to be used to create the first set of spacers **5** can be silicon-dioxide (e.g. TEOS-oxide) and the third material to be used to create the second set of spacers **7** can be nitride. In this case there is a need to deposit an extra stopping layer onto the SOI layer **2** to avoid/limit SOI recess during the patterning of the temporary pattern **3**.

### II. Method for "fin sextupling".

The method as described in previous part can be extended towards the formation of six individual fins, all spacer-defined and very close to each other starting from one lithographic (temporary) pattern.

The method, referred to as "fin sextupling" is schematically shown in Figures 5A to 5K and described in detail below.

Referring to Figure 5A the method preferably starts from a Silicon On Insulator (SOI) wafer. More specifically, the top Si- or SOI-layer **12** is preferably p-type mono-crystalline and <100>-oriented and has typically a thickness in between 50 nm to 200 nm.

The buried oxide (BOX) layer **11**, which is situated underneath the SOI layer, has typically a thickness in between 100 nm to 200 nm.

The bulk Si part of the substrate is preferably p-type mono-crystalline and <100>-oriented.

The method of forming multiple (six) fins starts with the formation of a temporary pattern or structure **13** made of a first material onto the SOI-layer **12**.

Suitable materials to be used as first material are commonly used hardmask materials such as TEOS- oxide, Plasma-Enhanced Chemically Vapor Deposition (PE-CVD) deposited silicon-dioxide, thermally grown SiO₂, etc

First a layer made of said first material is deposited onto the SOI layer **12** (with preferred thickness of around 80 nm) followed by the deposition of standard photolithographic layers (not shown).

Optical lithography (193 nm) is used to pattern the photosensitive layer(s).

The patterning of temporary pattern (structure) 13 is preferably done by means of reactive ion etching (also referred to as dry etching in this application) stopping on the SOI layer **12**.

A fluor comprising plasma can be used in case the first material is silicon-dioxide (TEOS-oxide), an example of such a plasma is a CF_{4/}CH₂F₂ plasma (with bias power) obtaining a selectivity of 3:1 for Si:SiO₂.

Figure 5A shows the final structure comprising the temporary pattern **13** after removal of remaining photosensitive material and residues by means of a strip process.

Subsequently a first conformal layer **14** made of a second material is deposited (Figure 5B). An example of said second material can be a silicon-nitride layer, with general chemical formula SiₓN_{y} or more specific Si₃N₄. Said silicon-nitride layer will be further referred to in this application as a "nitride" layer. Said nitride layer is preferably deposited by means of conformal deposition techniques such as Low-Pressure Chemical Vapor Deposition (LP-CVD), Plasma-Enhanced Chemical Vapor Deposition (PE-CVD), etc. The thickness of said deposited nitride layer is minimum 5nm, said thickness will determine the width of the fins obtained in the layer underneath. The minimal thickness of the fin that can be achieved is further dependent on the aspect ratio *A* (meaning the proportional relationship of the height *h* of the fin to the width *w* of the fin or *A*= *h_{fin}*/ *W_{fin}).* A too high aspect ratio needs to be avoided with respect to line collapse.

By means of reactive ion etching said first conformal layer **14** is etched back stopping on the temporary structure **13**, resulting in a first set of spacers **15** situated at the sidewalls of the temporary pattern **13** (Figure 5C).

Sufficient etch selectivity is required with respect to the SOI-layer **12**.

In case the second material is a nitride layer, the etchback can be performed using e.g. a CH₃F/CF₄/O₂ plasma (with bias power) obtaining a selectivity of about 15:1 for both oxide and Si compared to nitride.

If residues remain after etchback, a sulphuric peroxide mixture and an ammonia peroxide mixture can be used to remove the residual etch products.

The temporary pattern **13** is then removed, said removal process is preferably a wet etching process which is selective to both the first set of (nitride) spacers 5 as to the SOI-layer **12**.

In case the second material (used to define the first set of spacers) is nitride, this wet etching process can be done in a diluted HF solution (e.g. 2.5 min. in 2% HF).

After removal of the temporary pattern **12** two freestanding spacer structures **15** are achieved, the distance between said spacers (also referred to as the first set of spacers) is determined by the width of the temporary structure, which is defined by photolithographic patterning.

Figure 5D schematically shows the resulting structure after removal of the temporary pattern **15**.

Subsequently a second conformal layer **16** made of a third material is uniformly deposited onto the first set of spacers 15 as schematically shown in Figure 5E.

A Silicon-dioxide layer such as TEOS-oxide can be used as third material (e.g. with aimed thickness of around 30 nm).

The second conformal layer **16** is then etched back using the SOI layer **12** as stopping layer; a plasma comprising CF₄/CH₂F₂ can be used to perform the anisotropically etching in case the third material is silicon-dioxide (e.g. TEOS-oxide). This finally results in a second set of spacers **17** situated adjacent to or next to the first set of (nitride) spacers **15** (Figure 5F).

After formation of the second set of spacers **17**, a third conformal layer **18** is deposited onto said first and second set of spacers.

Said third conformal layer **18** is preferably made of said second material (or in other words identical to the first conformal layer **14**). Alternatively a fourth material can be used as third conformal layer as long as the etch selectivity is comparable to the second material.

An example of said second material can be a nitride layer deposited by means of LP-CVD.

By means of reactive ion etching said third conformal layer **18** will be etched back stopping on the SOI layer **12**, resulting in a third set of spacers **19** situated onto the outer sidewalls of said second set of spacers **17** and made of similar material of said first set of spacers **15**.

By removing the second set of spacers (silicon-dioxide), three free standing spacer structures made of similar material (e.g. nitride) are achieved.

The removal of the second set of spacers is preferably done by means of a wet removal process (e.g. a wet removal in 2% HF in case TEOS-oxide spacers are used).

The first **15** and third **19** set of spacers can then be used as a mask set to define fins **20** in the layer situated underneath the spacer structures (in SOI layer **12**).

The patterning of the fins **20** is preferably done by means of an anisotropically dry etching process.

After removal of the first **15** and third **19** set of spacers a final structure is obtained with multiple fins **20** (here three) wherein the distance between adjacent fins **20** is determined by the thickness of the deposited conformal layers **14, 16, 18**.

In case the first **15** and third **17** set of spacers is made of nitride a wet removal process in H₃PO₃ can be applied.

As an alternative and also preferred, the first material to be used to define the temporary pattern **13** can be silicon-dioxide (e.g. TEOS-oxide), the second material to be used to create the first and third set of spacers **15, 19** can be nitride and the third material to be used to create the second set of spacers **17** can be SiON.

In another alternative, the first material to be used to define the temporary pattern **13** can be nitride, the second material to be used to create the first and third set of spacers **15, 19** can be silicon-dioxide (e.g. TEOS-oxide) and the third material to be used to create the second set of spacers **17** can be nitride.

In still another alternative, the first material to be used to define the temporary pattern **13** can be silicon (Si) or Germanium (Ge) or Silicon-Germanium (Siₓ/Ge_{y} e.g. x=70, y=30), the second material to be used to create the first and third set of spacers **15, 19** can be silicon-dioxide (e.g. TEOS-oxide) and the third material to be used to create the second set of spacers **17** can be silicon-nitride. When using SiGe or Ge, said silicon-nitride layer is preferably deposited with a lower thermal budget, an example could be ^{™}Si₃N₄gen, a silicon-nitride layer deposited by a high-temperature CVD system from Applied Materials, the so called the SiNgen^{™} Centura. This system operates at a lower deposition temperature than conventional methods to minimize the amount of time the wafer is exposed to high temperatures. In case a silicon (Si), Germanium (Ge) or Silicon-Germanium is used as temporary pattern, there is also a need to deposit an extra stopping layer (e.g. 4nm thermally grown oxide) onto the SOI layer **2** to avoid/limit SOI recess during the patterning of the temporary pattern **13**.

It must be clear that combinations of the above described methods referred to as "fin quadrupling" and "fin sextupling" are also part of the invention.

The combination of depositing a conformal layer and spacer defined patterning of said conformal layer can be repeated and altered such that very high density of fins can be achieved.

### EXAMPLES

### Example 1: Fin Quadrupling processing

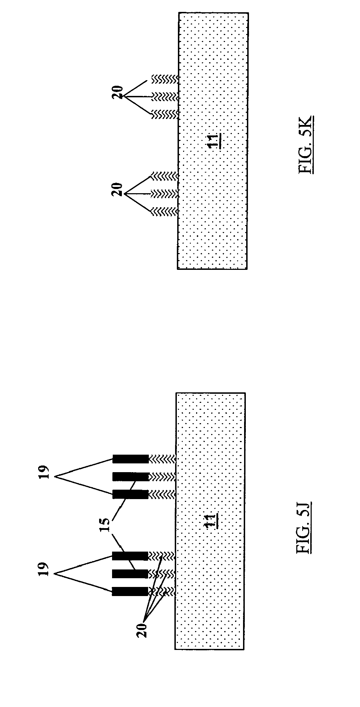

The experiment starts from a stack comprising following layers: 65nm Si/60nm TEOS-oxide/77nm BARC/ 230nm resist (193nm). The different process steps are illustrated in Figures 6A to 6F.

Optical lithography (193nm) is used to pattern a sacrificial hardmask (HM), said sacrificial HM (also referred to in this application as a temporary structure) is made of TEOS-oxide. The BARC layer and the sacrificial HM are opened stopping on the SOI layer (see Figure 6A).

Subsequently 30nm of LP-CVD (Low-Pressure Chemical Vapor Deposition) nitride is deposited on top of the pattern defined by the sacrificial hardmask structure. Consequently a spacer is formed on the sidewalls of the sacrificial hardmask structure. After spacer etch, the wafer is exposed subsequently to a sulphuric peroxide mixture and an ammonia peroxide mixture to remove residual etch products.

In the next process step, the sacrificial HM structure is removed selectively to both the sacrificial nitride spacer as the SOI-layer. This was done in a 2% HF solution (2.5min). This illustrated in Figure 6B.

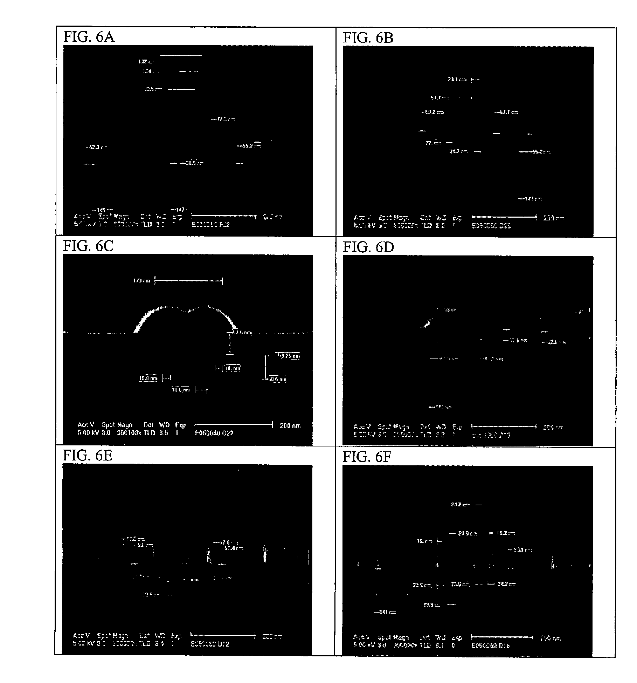

As the sacrificial nitride spacers have been defined and the sacrificial HM structure is removed, a TEOS-oxide film of 30nm is deposited. The source/drain pads are defined with conventional lithography (193nm). Consequently, the oxide layer is removed anisotropically resulting in a second generation of spacers (silicon-dioxide spacers) next to the sacrificial nitride spacers (shown in Figure 6C). Selectivity to the SOI-layer is desired.

A CH₃F/CF₄/O₂ comprising plasma is used for dry removal of the sacrificial nitride spacers (shown in Figure 6D with use of a contrast layer). Said CH₃F/CF₄/O₂ comprising plasma is selective to both silicon-dioxide and Si resulting in an silicon-dioxide HM (made of silicon-dioxide spacers) on top of an SOI-layer with limited recess.

After definition of the hardmask pattern for fins (made of previously formed silicon-dioxide spacers), source and drain, finally the SOI-layer is patterned. In Figure 6E an XSEM image of fins is shown after patterning: 4 separate fins have been etched into the SOI layer starting from one sacrificial silicon-dioxide line (Figure 6A). This clearly demonstrates the concept of fin quadrupling (the slope of the profile of the sacrificial HM can be further improved which will avoid CD difference between middle and outer fins). The distance between the middle fins corresponds to the line width of the sacrificial HM or temporary structure (Figure 6A) whereas the distance between the two outer fins is determined by the width of the sacrificial nitride spacer (Figure 6B). An XSEM image after silicon-dioxide HM is removal (2% HF solution, 30s) is shown in Figure 6F. The outer fins are less high compared to the inner fins due to the recess in the SOI layer caused by the sacrificial HM opening (Figure 6A) followed by the sacrificial nitride spacer etch (Figure 6B).

## Claims

1. A method for forming a mask on a layer to be patterned (2) in the manufacture of a semiconductor device comprising the steps of:
- depositing over one or more temporary structure(s) (3) made of a first material, a first conformal layer (4) of a second material,
- removing said first conformal layer (4) such as to form a first generation of spacers made of said second material,
- removing said temporary structure(s) (3),
- depositing over said first generation of spacers a second conformal layer (6) made of a third material,
- removing said second conformal layer (6) such as to form a second generation of spacers made of said third material,
- removing the first generation of spacers made of said second material.

2. A method according to claim 1, further comprising the steps of:
- depositing a third conformal layer made of said second material over said second generation of spacers,
- removing said third conformal layer such as to form a third generation of spacers made of said second material,
- removing the second generation of spacers made of said third material.

3. A method according to claim 1, further comprising the steps of:
- depositing a third conformal layer made of a fourth material over said second generation of spacers,
- removing said third conformal layer such as to form a third generation of spacers made of said fourth material,
- removing the second generation of spacers made of said third material.

4. A method according to claim 2, wherein said step of removing said first generation of spacers made of said second material is optional.

5. A method according to any of claims 1 to 4 wherein said temporary structure(s) is (are) freestanding structure (s) .

6. A method according to any of claims 1 to 4, wherein said temporary structure(s) is (are) (an) inlaid structure(s).

7. A method according to any of claims 1 to 6, wherein said temporary structure(s) is (are) created using photolithography.

8. A method according to any of claims 1 to 5, wherein said temporary structure(s) is (are) made of a previous generation of spacers.

9. A method according to any of claims 1 to 8, wherein said layer underneath to be patterned (2) is a Silicon On Insulator (SOI) wafer.

10. A method according to any of claims 1 to 9, wherein said first material is silicon-dioxide, said second material is silicon-nitride (SiₓN_{y}) and said third material is silicon-dioxide.

11. A method according to any of claims 1 to 9, wherein said first material is silicon-dioxide, said second material is silicon-nitride and said third material is SiON.

12. A method according to any of claims 1 to 9, wherein said first material is silicon-nitride, said second material is silicon-dioxide, and said third material is silicon-nitride.

13. A method according to any of claims 1 to 9, wherein said first material is silicon or Germanium or Silicon-Germanium, said second material is silicon-dioxide and said third material is silicon-nitride.

14. A method according to any of claims 1 to 13, wherein said nitride is deposited by means of conformal chemical vapor deposition techniques such as LP-CVD (low-pressure CVD) and PE-CVD (plasma-enhanced CVD).

15. A method according to any of claims 10 to 14, wherein said silicon-dioxide is CVD deposited TEOS-oxide.

16. A method according to any of claims 1 to 15, wherein the step of removing the temporary structure(s) (3) is an etching process, more particularly a wet etching process.

17. A method according to any of claims 1 to 16, wherein the step of removing said generation of spacers is an etching process, more particularly a wet etching process.

18. A method according to any of claims 1 to 17, wherein said conformal layer(s) ((4) and/or (6)) is/are etched back by means of reactive ion etching using a fluor comprising plasma.

19. Use of a method according to any of claims 1 to 18 for the manufacture of a MugFET device, wherein said mask is used for patterning a plurality of fins in said underneath layer to be patterned (2).

20. Use of a method according to any of claims 1 to 19 wherein said patterning for fins is used in combination with a resist-based patterning of source/drain patterning.

21. A device obtainable by a method according to claims 19 and 20.

22. A device of claim 21, wherein the distance between adjacent fins is comprised between 10 nm and 80 nm.

23. A device according to claim 21, wherein the distance between adjacent fins is about 20 nm.

24. A device according to any of claims 21 to 23, wherein the width of the fins is comprised between 10 nm and 20 nm.
